# EUROPEAN PATENT APPLICATION

(11) **EP 4 712 755 A2**
(43) Date of publication of application: **18.03.2026**
(21) Application number: 25196394.8
(22) Date of filing: 18.08.2025
(51) Int. Cl.: H10P 90/00, H10P 14/60, C23C 16/455, H10P 14/692

(54) **METHODS FOR FILLING RECESSED FEATURES ON A SUBSTRATE WITH A FLOWABLE LAYER STRUCTURE**

(30) Priority: 20.08.2024 US 202463684991 P
(71) Applicant: ASM IP Holding B.V., 1322 AP Almere (NL)
(72) Inventor: RODRIGUEZ, Leonard, 1322 AP Almere (NL); BALSEANU, Mihaela, 1322 AP Almere (NL)
(74) Representative: V.O.

(57) **Abstract**

Methods for filling a recessed feature on a substrate are disclosed. The methods disclosed include depositing a flowable layer structure on the substrate and heating the flowable layer structure above the glass transition temperature of the flowable layer structure. Methods for depositing the flowable layer structure include depositing an aluminum oxide based flowable layer structure employing atomic layer deposition processes.

## Description

### FIELD

The present disclosure generally relates to the field of semiconductor processing methods, and to the field of device and integrated circuit manufacture. More particularly, the present disclosure relates to methods of forming a flowable layer structure comprising aluminum oxide and for filling recessed features on a substrate employing a flowable layer structure.

### BACKGROUND

Flowable layers are widely used in semiconductor device manufacturing processes for various purposes. For example, flowable layers can be useful for filling narrow and high-aspect-ratio structures in advanced semiconductor devices, as they can fill geometries with high aspect ratios and are capable of filling small features with little overburden. In addition, flowable layers can reduce the complexity and cost of device manufacture, especially when compared to traditional spin-on technologies such as flowable layers can significantly reduce the number of removal steps and the associated costs, thereby simplifying the manufacturing process. Further, flowable layers can add versatility in certain applications as the flowable layers can also be used for surface defect masking, planarizing with capping films, and the like.

Borophosphosilicate glass (BPSG) is a common flowable material used in semiconductor manufacturing. For example, in intermetal Dielectric (IMD) applications, BPSG can be used as an insulating layer between different metal layers. In pre-metal dielectric (PMD) applications, BPSG can serve as a dielectric layer before the deposition of metal layers thereby helping to isolate a silicon substrate from the metal interconnects. In planarization applications, BPSG planarize the surface of the semiconductor substrate, making it smoother and more uniform for subsequent photolithography steps. In addition, in passivation layer applications, BPSG can function as a protective layer over the semiconductor devices, shielding them from contaminants and mechanical damage.

However, there are a number of common problems associated with the use of flowable BPSG glasses. While BPSG can reflow at elevated temperatures to aid in planarization, this property can also lead to issues with thermal stability during subsequent processing steps. In addition, the incorporation of boron and phosphorus in BPSG can introduce stress in the glass, leading to potential cracking and reliability issues. Accordingly, alternative flowable layers and methods of forming and using such flowable layers are desired.

Any discussion, including discussion of problems and solutions, set forth in this section has been included in this disclosure solely for the purpose of providing a context for the present disclosure. Such discussion should not be taken as an admission that any or all of the information was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

Various embodiments of the present disclosure relate to a method for filling a recessed feature on a substrate disposed within a reaction chamber, the method comprising: depositing a flowable layer structure on the substrate by performing a plurality of deposition super-cycles of an atomic layer deposition process, each one of the plurality of deposition super-cycles comprising: performing one or more first sub-cycles of a first ALD process to deposit an aluminum oxide layer, each one of the one or more first sub-cycles comprising: introducing an aluminum precursor into the reaction chamber; and introducing a first oxygen reactant into the reaction chamber; and performing one or more second sub-cycles of a second ALD process to deposit a doping metal oxide layer, each one of the one or more second sub-cycles comprising: introducing one or more dopant precursors; and introducing a second oxygen reactant, wherein the one or more dopant precursors comprise a doping element having an oxidation state equal to the oxidation state of aluminum and an ionic radius different to that of aluminum; and heating the flowable layer structure at a temperature equal to or greater than the glass transition temperature of the flowable layer structure.

In some embodiments the doping element is selected from the group consisting of lanthanides elements, group IIIA elements, and group IIB elements.

In some embodiments the doping element is selected from the group consisting of lanthanum (La), yttrium (Y), cerium (Ce), ytterbium (Yb), praseodymium (Pr), europium (Eu), scandium (Sc), lutetium (Lu), erbium (Er), gallium (Ga), dysprosium (Dy), and indium (In).

In some embodiments the flowable layer structure comprises a super-lattice structure comprising two or more repeating unit layer structures, each unit layer structure comprising an aluminum oxide/doping metal oxide bilayer, wherein adjacent doping metal oxide layers in the super-lattice structure comprise different doping elements having a different ionic radius.

In some embodiments a difference in ionic radius between the doping elements in adjacent doping metal oxide layers of the super-lattice structure is between 0.04 Angstroms and 0.74 Angstroms.

In some embodiments adjacent doping metal oxide layers in the super-lattice structure comprise different doping elements having a different coordination number.

In some embodiments a difference in the coordination number between the doping elements in adjacent doping metal oxide layers of the super-lattice structure is between 1 and 6.

In some embodiments the method further comprises performing one or more first sub-cycles to deposit an initial aluminum oxide layer on the substrate prior to depositing the super-lattice structure; and performing one or more first sub-cycles to deposit a capping aluminum oxide layer on the super-lattice structure.

In some embodiments each one of the first sub-cycles further comprises introducing a silicon precursor into the reaction chamber.

In some embodiments heating the flowable layer structure further comprises thermally annealing the flowable layer structure in an environment comprising water vapor.

Various additional embodiments of the present disclosure relate to a method for filling a recessed feature on a substrate with a flowable layer structure, the method comprising: performing an atomic layer deposition (ALD) process for depositing a super-lattice structure comprising two or more repeated aluminum silicate (AlSiₓO_{y})/doping metal oxide (MO_{z}) bilayers, the ALD process comprising a deposition super-cycle comprising alternately and sequentially performing one or more first sub-cycles and one or more second sub-cycles; wherein each cycle of the first sub-cycles comprises alternately and sequentially contacting the substrate with an aluminum precursor, a silicon precursor, and a first oxygen precursor; wherein each cycle of the second sub-cycles comprises alternatively and sequentially contacting the substrate with a dopant precursor and a second oxygen reactant; and wherein adjacent AlSiₓO_{y}/MO_{z} bilayers in the super-lattice structure are deposited employing a different dopant precursor such each of the adjacent AlSiₓO_{y}/MO_{z} bilayers comprises a doping element that is different, having a different ionic radius and a different coordination number; and heating the flowable layer structure at a temperature equal to or greater than the glass transition temperature of the flowable layer structure.

In some embodiments the difference in ionic radius between the doping elements in adjacent doping metal oxide layers of the super-lattice structure is between 0.04 Angstroms and 0.74 Angstroms.

In some embodiments the difference in the coordination number between the doping elements in adjacent doping metal oxide layers of the super-lattice structure is between 1 and 6.

In some embodiments the method further comprised performing one or more first sub-cycles to deposit an initial AlSiₓO_{y} layer on the substrate prior to depositing the super-lattice structure; and performing one or more first sub-cycles to deposit a capping AlSiₓO_{y} layer on the super-lattice structure.

In some embodiments the doping element comprises a lanthanide element selected from the group consisting of lanthanum (La), cerium (Ce), ytterbium (Yb), praseodymium (Pr), europium (Eu), lutetium (Lu), erbium (Er), dysprosium (Dy).

In some embodiments the doping element comprises a group IIIA element selected from the group consisting of gallium (Ga), and indium (In).

In some embodiments the doping element comprises a group IIIB element selected from the group consisting of scandium (Sc), and yttrium (Y).

Various additional embodiments of the present disclosure relate a method for filling a recessed feature on a substrate disposed within a reaction chamber, the method comprising: depositing a flowable doped aluminum silicate (AlSiₓO_{y}) layer structure at least partially within the recessed feature of the substrate, the doped AlSiₓO_{y} structure comprising: an initial AlSiₓO_{y} layer, a super-lattice structure disposed on the initial AlSiₓO_{y} layer and comprising two or more repeated AlSiₓO_{y}/metal oxide (MO_{z}) bilayers, wherein adjacent metal oxide (MO_{z}) layers in the super-lattice structure each comprise a different doping element having a different ionic radius and a different coordination number; and a capping AlSiₓO_{y} layer disposed on the super-lattice structure; and heating the flowable doped aluminum silicate (AlSiₓO_{y}) layer structure above a glass transition temperature of the flowable doped aluminum silicate (AlSiₓO_{y}) layer structure in an environment comprising water vapor to induce the reflow of the flowable doped aluminum silicate (AlSiₓO_{y}) layer structure thereby at least partially filling the recessed feature.

In some embodiments the super-lattice structure is deposited by performing a plurality of deposition super-cycles of an atomic layer deposition process, each one of the plurality of deposition super-cycles comprising: performing one or more of first sub-cycles to deposit an AlSiₓO_{y} layer, each one of the plurality of the first sub-cycles comprising: introducing an aluminum precursor into the reaction chamber; introducing a silicon precursor into the reaction chamber, and introducing a first oxygen reactant into the reaction chamber; and performing one or more of second sub-cycles to deposit a doping metal oxide layer, each one of the plurality of the second sub-cycles comprising: introducing one or more dopant precursors; and introducing a second oxygen reactant.

In some embodiments the first sub-cycle is performed between 1 and 10 times, and the second sub-cycle is performed between 1 and 5 times.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

To easily identify the discussion of any particular element or act, the most significant digit or digits in a reference number refer to the figure number in which that element is first introduced.

A more complete understanding of the embodiments of the present disclosure may be derived by referring to the detailed description and claims when considered in connection with the following illustrative figures.
FIG. 1 illustrates a method for filling a recessed feature on a substrate with a flowable layer structure in accordance with one or more embodiments.
FIG. 2 illustrates a method for depositing a flowable layer structure in accordance with one or more embodiments.
FIG. 3 illustrates a method for depositing a super-lattice structure in accordance with one or more embodiments.
FIG. 4 illustrates a structure including a substrate having a recessed feature in accordance with one or more embodiments.
FIG. 5 illustrates a structure including a flowable layer structure on a recessed feature of a substrate in accordance with one or more embodiments.
FIG. 6 illustrates a structure including a recessed feature filled by a flowable layer structure in accordance with one or more embodiments.
FIG. 7 illustrates a cross-sectional view of a flowable layer structure in accordance with one or more embodiments.
FIG. 8 is a table showing the ionic radius and coordination number of various elements constituting a flowable layer structure in accordance with one or more embodiments.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Layers deposited within a recessed feature, such as a trench structure, for example, typically fail to complete fill the opening of the recessed feature. The incomplete filling of the recessed feature can create a seam, or a multitude of voids positioned down the center of the filled recessed feature. This seam/void is a defect that can have a detrimental effect on subsequent fabrication process and device performance. For example, the seam/void may allow an etchant solution to rapidly pass through the center of the incompletely filled recessed feature which can reduce the effective cross-section of the feature with regards to resistivity, or other material property.

Flowable layers (and flowable layer structures) can address the problem with incomplete filling of recessed features by allowing the flowable layer to deform at moderately elevated temperatures in order to better conform to the underlying substrate and/or fill voids. However, currently available flowable materials are commonly silica based, such as BPSG, and alternative flowable materials are desired to exploit differing material properties while retaining the desirable flowable attributes.

Accordingly various embodiments provided include flowable layer structures comprising aluminum oxides including aluminum silicate materials and aluminum silicate layer structures including doping metal oxide layers. As used here the term "aluminum oxide layer" can refer to a layer of material comprising aluminum and oxygen, and can include aluminum oxide layers (AlOₓ layers), and aluminum silicate layers (AlSiₓO_{y} layers). In embodiments where the aluminum oxide layer comprises an aluminum silicate layer (AlSiₓO_{y} layer) the aluminum silicate layer may comprise alternating layers of an aluminum oxide (AlOₓ) and a silicon oxide (SiOₓ).

In this disclosure, "gas" can include material that is a gas at normal temperature and pressure (NTP), a vaporized solid and/or a vaporized liquid, and can be constituted by a single gas or a mixture of gases, depending on the context. A gas other than the process gas, i.e., a gas introduced without passing through a gas distribution assembly, other gas distribution device, or the like, can be used for, e.g., sealing the reaction space, and can include a seal gas. Precursors and reactants can be gasses. Exemplary seal gasses include noble gasses, nitrogen, and the like. In some cases, the term "precursor" can refer to a compound that participates in the chemical reaction that produces another compound, and particularly to a compound that constitutes a film matrix or a main skeleton of a film; the term "reactant" can be used interchangeably with the term precursor.

As used herein, the term "substrate" can refer to any underlying material or materials that can be used to form, or upon which, a device, a circuit, or a film can be formed by means of a method according to an embodiment of the present disclosure. A substrate can include a bulk material, such as silicon (e.g., single-crystal silicon), other Group IV materials, such as germanium, or other semiconductor materials, such as Group II-VI or Group III-V semiconductor materials and can include one or more layers overlying or underlying the bulk material. Further, the substrate can include various features, such as recesses, protrusions, and the like formed within or on at least a portion of a layer of the substrate. By way of example, a substrate can include bulk semiconductor material and an insulating or dielectric material layer overlying at least a portion of the bulk semiconductor material. Further, the term "substrate" may refer to any underlying material or materials that may be used, or upon which, a device, a circuit, or a film may be formed. The "substrate" may be continuous or non-continuous; rigid or flexible; solid or porous. The substrate may be in any form such as a powder, a plate, or a workpiece. Substrates in the form of a plate may include wafers in various shapes and sizes. Substrates may be made from materials, such as silicon, silicon germanium, silicon oxide, gallium arsenide, gallium nitride and silicon carbide for example. A continuous substrate may extend beyond the bounds of a process chamber where a deposition process occurs and may move through the process chamber such that the process continues until the end of the substrate is reached. A continuous substrate may be supplied from a continuous substrate feeding system allowing for manufacture and output of the continuous substrate in any appropriate form. Non-limiting examples of a continuous substrate may include a sheet, a non-woven film, a roll, a foil, a web, a flexible material, a bundle of continuous filaments or fibers (i.e., ceramic fibers or polymer fibers). Continuous substrates may also comprise carriers or sheets upon which non-continuous substrates are mounted.

As used herein, the term "film" and/or "layer" can refer to any continuous or non-continuous structure and material, such as material deposited by the methods disclosed herein. For example, a film and/or layer can include two-dimensional materials, three-dimensional materials, nanoparticles, partial or full molecular layers or partial or full atomic layers or clusters of atoms and/or molecules. A film or layer may comprise, or may consist at least partially of, a plurality of dispersed atoms on a surface of a substrate and/or may be or may become embedded in a substrate and/or may be or may become embedded in a device manufactured on that substrate. A film or layer may comprise material or a layer with pinholes and/or isolated islands. A film or layer may be at least partially continuous. A film or layer may be patterned, e.g., subdivided, and may be comprised in a plurality of semiconductor devices. A film or layer may be selectively grown on some parts of a substrate, and not on others.

The term "cyclic deposition process" or "cyclical deposition process" can refer to the sequential introduction of precursors (and/or reactants) into a reaction chamber to deposit a layer over a substrate and includes processing techniques such as atomic layer deposition (ALD), cyclical chemical vapor deposition (cyclical CVD), and hybrid cyclical deposition processes that include an ALD component and a cyclical CVD component.

The term "atomic layer deposition" can refer to a vapor deposition process in which deposition cycles, typically a plurality of consecutive deposition cycles, are conducted in a process chamber. The term atomic layer deposition, as used herein, is also meant to include processes designated by related terms, such as chemical vapor atomic layer deposition, atomic layer epitaxy (ALE), molecular beam epitaxy (MBE), gas source MBE, organometallic MBE, and chemical beam epitaxy, when performed with alternating pulses of precursor(s)/reactive gas(es), and purge (e.g., inert carrier) gas(es). A pulse can comprise exposing a substrate to a precursor or reactant. This can be done, for example, by introducing a precursor or reactant to a reaction chamber in which the substrate is present. Additionally, or alternatively, exposing the substrate to a precursor can comprise moving the substrate to a location in a substrate processing system in which the reactant or precursor is present.

Generally, for ALD processes, during each cycle, a precursor is introduced into a reaction chamber and is chemisorbed onto a deposition surface (e.g., a substrate surface that can include a previously deposited material from a previous ALD cycle or other material) and forming about a monolayer or sub-monolayer of material that does not readily react with additional precursor (i.e., a self-limiting reaction). Thereafter, a reactant (e.g., another precursor or reaction gas) may subsequently be introduced into the process chamber for use in converting the chemisorbed precursor to the desired material on the deposition surface. The reactant can be capable of further reaction with the precursor. Purging steps can be utilized during one or more cycles, e.g., during each step of each cycle, to remove any excess precursor from the process chamber and/or remove any excess reactant and/or reaction byproducts from the reaction chamber.

As used herein, a "precursor" includes a gas or a material that can become gaseous and that can be represented by a chemical formula that includes an element which may be incorporated during a deposition process as described herein. In addition, the terms "precursor" and "reactant" can refer to molecules (compounds or molecules comprising a single element) that participate in a chemical reaction that produces another compound. A precursor typically contains portions that are at least partly incorporated into the compound or element resulting from the chemical reaction in question. Such a resulting compound or element may be deposited on a substrate. A reactant may be an element or a compound that is not incorporated into the resulting compound or element to a significant extent. However, a reactant may also contribute to the resulting compound or element in certain embodiments.

As used herein, a "structure" can be or include a substrate as described herein. Structures can include one or more layers overlying or within the substrate, such as one or more layers formed according to a method as described herein. Full devices or partial device portions can be included within or on structures.

As used herein, the term "recessed feature" may refer to an opening or cavity disposed between surfaces of a non-planar surface. For example, the term "recessed feature" may refer to an opening or cavity disposed between opposing sidewalls or protrusions extending vertically from the surface of a substrate or opposing inclined sidewalls of an indentation extending vertically into the surface of a substrate.

As used herein, the term "seam" may refer to a void line or one or more separated voids formed by the abutment of edges formed in a gap-fill metal. The presence of a "seam" can be confirmed using high magnification microscopy methods, such as, for example, scanning transmission electron microscopy (STEM), and transmission electron microscopy (TEM), wherein if observations reveals a clear vertical void line or one or more vertical voids in a recessed feature filled with a gap-fill metal then a "seam" is deemed to be present.

A number of example materials are given throughout the embodiments of the current disclosure; it should be noted that the chemical formulas given for each of the example materials should not be construed as limiting and that the non-limiting example materials given should not be limited by a given example stoichiometry.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicated herein can be relative or absolute percentages.

In the specification, it will be understood that the term "on" or "over" may be used to describe a relative location relationship. Another element, film or layer may be directly on the mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly, to this, it will be understood the term "under," "underlying," or "below" will be construed to be relative concepts.

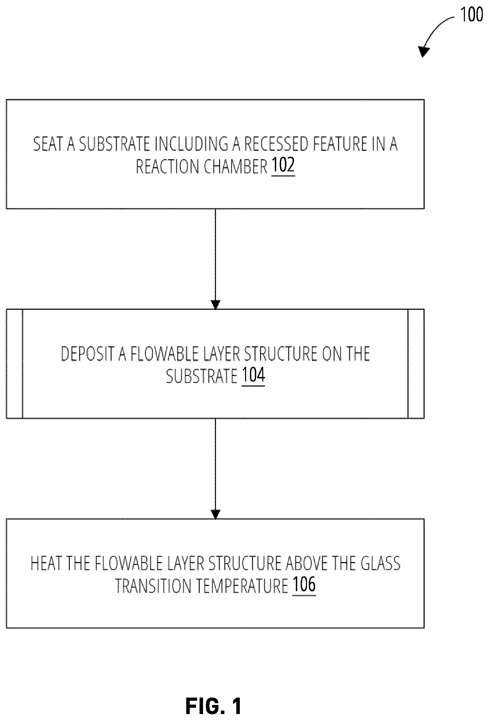

Turning now to the figures, FIG. 1 illustrates a method 100 for filling a recessed feature on a substrate with a flowable layer structure. In brief method 100 comprises, seating a substrate including a recessed feature within a reaction chamber (step 102), depositing a flowable layer structure on the substrate (e.g., on the recessed feature) (deposition process 104), and heating the flowable layer structure at a temperature equal to or greater than the glass transition temperature of the flowable layer structure (step 106).

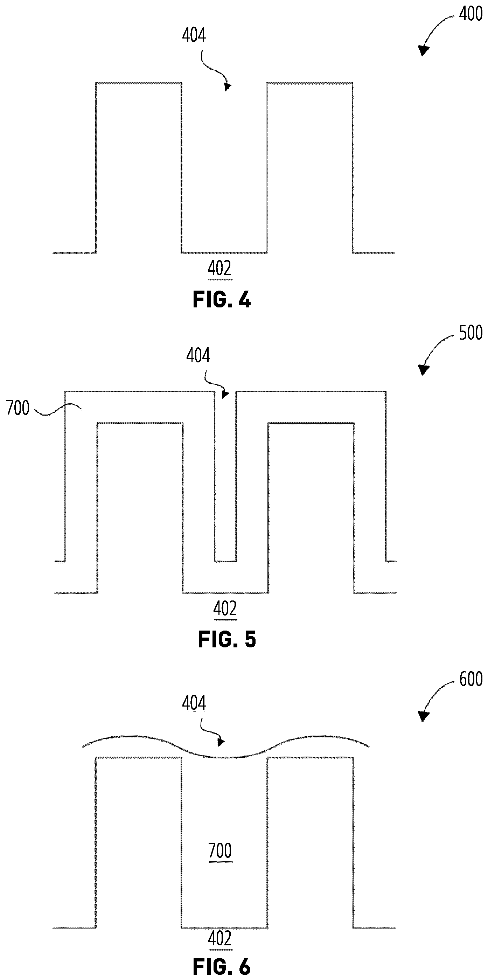

In more detail, the substrate on which the flowable layer structure is deposited can include a recessed feature or a plurality of recessed features. FIG. 4 illustrates an exemplary structure 400 including a substrate 402 (as described above) and a recessed feature 404. The structure 400 may comprise a portion of a device structure, such as, a partially fabricated device structure. The structure 400 may comprise a partially fabricated logic device, memory device, integrated circuit, and the like. Although structure 400 is illustrated as including a single recessed feature 404 it should be appreciated that the methods provided are not so limited, and substrates including a plurality of recessed features can be filled, by the methods disclosed herein. The cross-sectional profile of the recessed feature 404 illustrated in FIG. 4 is exemplary and the various embodiments provided can fill recessed features with alternative cross-sectional profiles, including, but not limited to, curved, scalloped, V-shaped, tapered, re-entrant, as well as through-silicon-via structures. The recessed feature 404 can also comprise a high aspect ratio feature, such as, for example, a trench structure, a vertical gap, and/or a fin structure. When referring to recessed features having a high aspect ratio, the recessed feature 404 has an aspect ratio (e.g., the ratio of height to width) that is greater than 2:1, greater than 5:1, greater than 10:1, greater than 25:1, greater than 50:1, or greater than 300:1.

In accordance with examples of the disclosure, the substrate is seated in a reaction chamber configured for deposition of the flowable layer structure. In such examples the reaction chamber can comprise a component or assembly of a single-wafer ALD reactor or a batch ALD reactor where deposition on multiple substrates takes place at the same time. In some embodiments the reaction chamber may form part of a cluster tool in which a variety of different processes for the fabrication of devices and/or integrated circuit are carried out. In some embodiments a flow-type reactor and associated reaction chamber can be utilized. In some embodiments a high-volume manufacturing-capable single wafer ALD reactor and associated reaction chamber can be used. In other embodiments a batch reactor comprising multiple substrates can be used. For embodiments in which batch ALD reactor are used, the number of substrates can be in the range of 10 to 300, in the range of 50 to 150, or in the range of 300 to 130.

In accordance with examples of the disclosure, the deposition of the flowable layer structure (deposition process 104 of method 100, as illustrated in FIG. 1) can comprise heating the substrate to a desired deposition temperature. In some embodiments the deposition temperature (i.e., the substrate temperature) at which the flowable layer structure is deposited can be between 100 °C to 600 °C, between 150 °C to 550 °C, between 200 °C to 500 °C, between 250 °C to 450 °C, or between 200 °C and 400 °C. In some embodiments the deposition temperature can be less than 600 °C, less than 500 °C, less than 400 °C, less than 300 °C, less than 250 °C, or less than 200 °C.

In addition to controlling the temperature of the substrate, the pressure in the reaction chamber may also be regulated to enable deposition of the flowable layer structure. For example, the pressure within the reaction chamber may be less than 760 Torr, or between 0.1 Torr and 10 Torr, or between 0.5 Torr and 5 Torr, or between 1 Torr to 4 Torr.

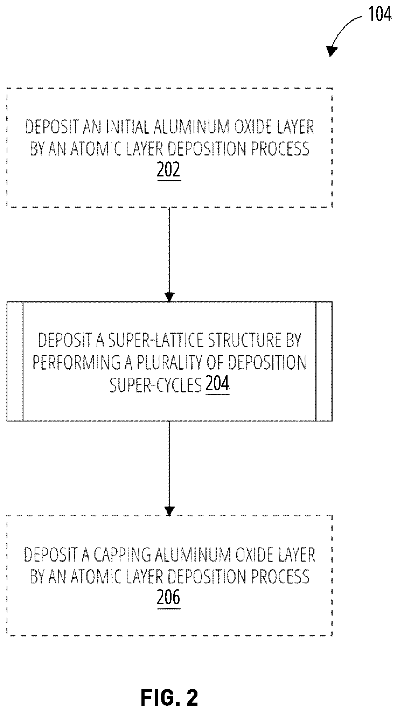

In accordance with examples of the disclosure, FIG. 2 illustrates the deposition process for depositing the flowable layer structure on the substrate in more detail (i.e., deposition process 104 of FIG. 1).

In some embodiments deposition process 104 for depositing the flowable layer structure can comprise: depositing an initial aluminum oxide layer on the substrate (step 202), depositing a super-lattice structure by performing one or more deposition super-cycles of an atomic layer deposition process (ALD super-cycle process 204), and depositing a capping aluminum oxide layer on the super-lattice structure (step 206). In such embodiments the flowable layer structure deposited by deposition process 104 comprises the initial aluminum oxide layer, the super-lattice structure, and the capping aluminum oxide layer where each of the constituent layers are flowable layers.

In some embodiments the deposition process 104 for depositing the flowable layer structure can omit the deposition of the initial aluminum oxide layer (step 202) and/or the deposition of the capping aluminum oxide layer (step 206). In such embodiments the flowable layer structure deposited by the deposition process 104 comprises the super-lattice structure where the super-lattice structure is a flowable super-lattice structure.

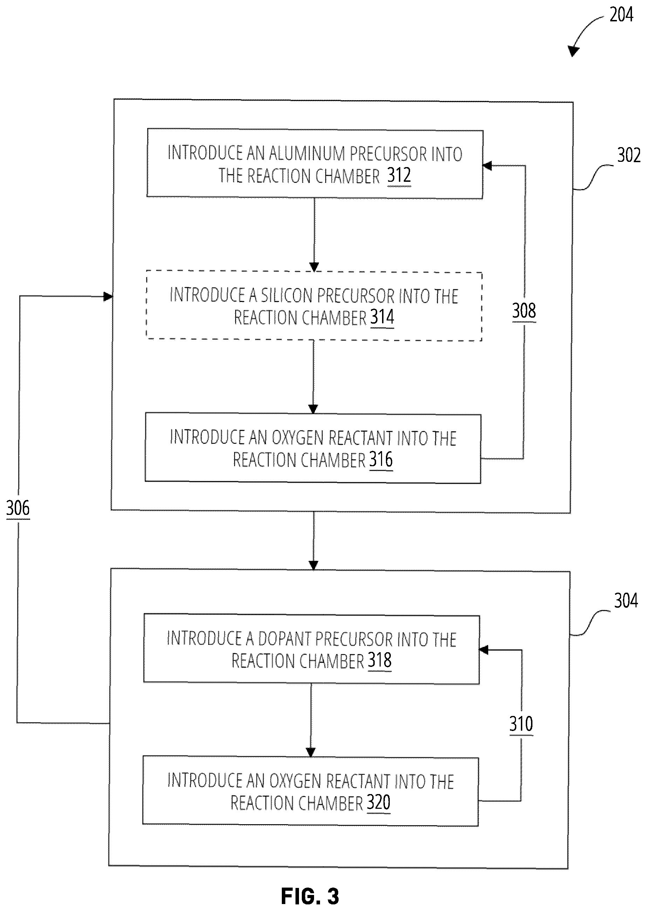

FIG. 3 illustrates the ALD super-cycle process 204 for depositing the super-lattice structure in greater detail. In accordance with examples of the disclosure, the ALD super-cycle process 204 comprises performing a plurality of deposition super-cycles, as denoted by super-cycle loop 306. In such examples each deposition super-cycle comprises performing one or more first sub-cycles of a first ALD process 302 to deposit an aluminum oxide layer and performing one or more second sub-cycles of a second ALD process 304 to deposit a doping metal oxide layer.

As illustrated in FIG. 3, the first ALD process 302 (of ALD super-cycle process 204) can comprise, performing one or more first sub-cycles (as denoted by first cycle loop 308). Each one of the first sub-cycles may comprise, introducing an aluminum precursor into the reaction chamber (sub-step 312), optionally introducing a silicon precursor into the reaction chamber (optional sub-step 314), and introducing a first oxygen reactant into the reaction chamber (sub-step 316). In embodiments where the aluminum oxide layer deposited by first ALD process 302 comprises an AlOₓ layer, the optional sub-step 314 of introducing the silicon precursor can be omitted. In embodiments where the aluminum oxide layer deposited by first ALD process 302 comprises an AlSiₓO_{y} layer, the optional sub-step 314 of introducing the silicon precursor is included. Sub-step 312, optional sub-step 314, and sub-step 316 can be repeated as illustrated by the first cycle loop 308. Further, sub-step 312, optional sub-step 314, and sub-step 316 can be initiated and/or terminated in any order. Yet further, the first ALD process 302 can include one or more repetitions (e.g., 1-10 or 1-5) of sub-step 312, optional sub-step 314, and/or sub-step 316 prior to proceeding to the other step of first ALD process 302.

In addition, ALD super-cycle process 204 includes the second ALD process 304 which can comprise, performing one or more second sub-cycles (as denoted by second cycle loop 310). Each one of the second sub-cycles may comprise introducing one or more dopant precursors into the reaction chamber (sub-step 318) and introducing a second oxygen reactant into the reaction chamber (sub-step 320). The second ALD process 304 can be employed to deposit a doping metal oxide layer (MO_{z}), as described in greater detail below. Sub-step 318 and sub-step 320 can be repeated as illustrated by the second cycle loop 310. Further, sub-step 318 and sub-step 320 can be initiated and/or terminated in any order. Yet further, the second ALD process 304 can include one or more repetitions (e.g., 1-10 or 1-5) of sub-step 318 and/or sub-step 320 prior to proceeding to the other step of second ALD process 304.

In various embodiments the first sub-cycle (of the first ALD process 302) can be performed between 1 and 10 times.

In various embodiments the second sub-cycle (of the second ALD process 304) can be performed between 1 and 5 times.

In various embodiments the super-lattice structure comprises repeating layers of an aluminum oxide (e.g., AlOₓ or AlSiₓO_{y}) and a doping metal oxide (e.g., MO_{z}). It should be appreciated that although the super-lattice structure is deposited as a super-lattice structure the individual layers of the super-lattice structure may not be discernable (e.g., by observation using high magnification methods such as transmission electron microscopy and the like). For example, in some embodiments the aluminum oxide layers and/or the doping metal oxide layers may be deposited at insufficient thickness to be observable, whereas in some embodiments the aluminum oxide layers, and the doping metal oxide layers may form a mixed material comprising aluminum, optionally silicon, oxygen, and the one or more doping elements.

In various embodiments introducing the precursor/reactant (e.g., aluminum precursors, silicon precursors, dopant precursors, and the oxygen reactants) can comprise pulsing the precursor/reactant into the reaction chamber wherein the precursor/reactant contacts the substrate disposed within the reaction chamber. For example, a pulse can comprise exposing a substrate to a precursor or reactant. This can be done, for example, by introducing a precursor or reactant to a reaction chamber in which the substrate is present. Additionally, or alternatively, exposing the substrate to a precursor can comprise moving the substrate to a location in a substrate processing system in which the reactant or precursor is present.

In accordance with examples of the disclosure, the precursors, and the oxygen reactants can be purged from the reaction chamber-e.g., after each pulse of precursor/reactant and/or upon completion of a first cycle loop 308, and/or a second cycle loop 310. In some embodiments, each first sub-cycle and each second sub-cycle of ALD super-cycle process 204 can also include one or more additional steps which can performed during each sub-cycle or during select deposition sub-cycles.

As previously described above, in some examples the flowable layer structure can include an initial aluminum oxide layer, the super-lattice structure, and a capping aluminum oxide layer where each of the constituent layers are flowable layers. In such examples the deposition of the flowable layer structure, as illustrated by deposition process 104 of FIG. 2, comprises the steps of depositing an initial aluminum oxide layer by an atomic layer deposition process (step 202), depositing a super-lattice structure (as described above) on the initial aluminum oxide layer, and depositing a capping aluminum oxide layer by an atomic layer deposition process on the super-lattice structure (step 206).

In some embodiments the ALD process for depositing the initial aluminum oxide layer (step 202) can be the same or substantially the same as the first ALD process 302 of ALD super-cycle process 204. In such embodiments depositing the initial aluminum oxide layer (step 202) can comprise introducing an aluminum precursor into the reaction chamber, optionally introducing a silicon precursor into the reaction chamber, and introducing an oxygen reactant into the reaction chamber. In embodiments where the initial aluminum oxide layer comprises an AlOₓ layer, the optional step of introducing the silicon precursor can be omitted. In other embodiments where the initial aluminum oxide layer comprises an AlSiₓO_{y} layer, the step of introducing the silicon precursor is included. The steps of introducing the silicon precursor, the optional silicon precursor, and the first oxygen reactant can be repeated and/or can be initiated and/or terminated in any order, as described above. Yet further, the ALD process (step 202) for depositing the initial aluminum oxide layer can include one or more repetitions (e.g., 1-10 or 1-5) of steps of introducing the aluminum precursor, the optional silicon precursor, and the first oxygen reactant prior to proceeding to the other step of ALD process of step 202.

In various embodiments the initial aluminum oxide layer can be deposited as a closed layer (e.g., a layer that encapsulates the underlying substrate). In some embodiments the initial aluminum oxide layer is deposited by performing the first sub-cycle (of the first ALD process 302) 5 or more times, 10 or more times, 15 or times, or 20 or more times, or more than 20 times, or between 1 and 10 times.

In some embodiments the ALD process for depositing the capping aluminum oxide layer (step 206) can be the same or substantially the same as the first ALD process 302 of ALD super-cycle process 204. In such embodiments depositing the capping aluminum oxide layer (step 206) can comprise introducing an aluminum precursor into the reaction chamber, optionally introducing a silicon precursor into the reaction chamber, and introducing an oxygen reactant into the reaction chamber. In embodiments where the capping aluminum oxide layer comprises an AlOₓ layer, the optional step of introducing the silicon precursor can be omitted. In other embodiments where the capping aluminum oxide layer comprises an AlSiₓO_{y} layer, the step of introducing the silicon precursor is included. The steps of introducing the silicon precursor, the optional silicon precursor, and the oxygen reactant can be repeated and/or can be initiated and/or terminated in any order, as described above. Yet further, the ALD process (step 206) for depositing the capping aluminum oxide layer can include one or more repetitions (e.g., 1-10 or 1-5) of steps of introducing the aluminum precursor, the optional silicon precursor, and the oxygen reactant prior to proceeding to the other step of ALD process of step 202.

In various embodiments the capping aluminum oxide layer can be deposited as a closed layer (e.g., a layer that encapsulates the underlying super-lattice structure). In some embodiments the capping aluminum oxide layer is deposited by performing the second sub-cycle (of the second ALD process 304) 5 or more times, 10 or more times, 15 or times, 20 or more times, more than 20 times, or between 1 and 10 times.

The aluminum precursor(s) employed for depositing the flowable layer structure can be utilized for the deposition of the super-lattice structure, as well as the optional initial aluminum oxide layer and the optional capping AlSiₓO_{y} layers (as described in detail below). In some embodiments the aluminum precursor is selected from the group consisting of trimethylaluminum (TMA), dimethylaluminumchloride, aluminumtrichloride (AlCl₃), dimethylaluminum isopropoxide (DMAI), tris(tertbutyl)aluminum (TTBA), tris(isopropoxide)aluminum (TIPA), and triethylaluminum (TEA). In some embodiments the aluminum precursor is dimethylaluminum isopropoxide (DMAI).

The silicon precursor(s) that are optionally employed for depositing the flowable layer structure can be utilized for the deposition of the super-lattice structure, as well as the optional initial aluminum oxide layer and the optional capping AlSiₓO_{y} layers (as described in detail below). In some embodiments the silicon precursor is selected from the group consisting of silanes, organosilanes, and chlorosilanes. For example, the silicon precursor can include a hydrogenated silicon precursor. In such examples the hydrogenated silicon precursor can be selected from a group consisting of silane (SiH₄), disilane (Si₂H₆), trisilane (Si₃H₈), and tetrasilane (Si₄H₁₀). In further examples the silicon precursor can comprise a silicon halide precursor. In such examples the silicon halide precursor can comprise a silicon chloride precursor selected from the group consisting of monochlorosilane (MCS), dichlorosilane (DCS), trichlorosilane (TCS), hexachlorodisilane (HCDS), octachlorotrisilane (OCTS), and silicon tetrachloride (STC). In further examples the silicon precursor can comprise a silicon iodide precursor. In such examples the silicon halide precursor can comprise a silicon iodide precursor selected from the group consisting of monoiodosilane, diiodosilane, triiodosilane, tetraiodosilane. In additional examples the silicon precursor can comprise an organosilane such as, an alkylsilane or an aminosilane. In such examples the silicon precursor can include one or more of tris(dimethylamino)silane, bis(tert-butylamino)silane, di(sec-butylamino)silane, trisilylamine, neopentasilane, bis(dimethylamino)silane, (dimethylamino)silane (DMAS), bis(diethylamino)silane (BDEAS), bis(ethylmethylamino)silane (BEMAS), tetrakis(dimethylamino)silane (TKDMAS), trimethylsilane, tetramethylsilane, silane, tetra(ethoxy)silane (TEOS), tris(tert-butoxy)silanol, tris(tert-pentoxy)silanol, and dimethyldichlorosilane.

The example deposition methods provided above (see for example deposition process 104 and ALD super-cycle process 204) employ one or more oxygen reactants for depositing the flowable layer structure. In some embodiments the oxygen reactant may comprise one or more of water (H₂O), ozone (O₃), and hydrogen peroxide (H₂O₂).

As illustrated in FIG. 3, the ALD super-cycle process 204 can include the introduction of a first oxygen reactant (sub-step 316) and the introduction of a second oxygen reactant (sub-step 320). In some embodiments the first oxygen reactant and the second oxygen reactant can comprise the same oxygen reactant (e.g., H₂O). In some embodiments the first oxygen reactant and the second oxygen reactant can comprise different oxygen reaction chambers (e.g., H₂O as the first oxygen reactant and H₂O₂ as the second oxygen reactant).

During the deposition of the super-lattice structure one or more dopant precursors are introduced into the reaction chamber, e.g., during the deposition of the doping metal oxide layers (sub-step 318 of ALD super-cycle process 204).

In some embodiments the dopant precursor comprises a doping element having an oxidation state equal to the oxidation state of the aluminum content in the flowable layer structure. In a particular embodiment the aluminum content in the flowable layer structure has an oxidation state of +3 and the dopant precursor comprising a doping element having an oxidation state of +3. In such embodiments the oxidation state of the aluminum and the doping elements can be equal so as to form a flowable layer structure which is in a neutral state, i.e., does not include mobile charge carriers. In some embodiments the dopant precursor comprises a doping element having a different ionic radius to aluminum and/or a different coordination number, as described in greater detail below.

In some embodiments, the dopant precursor comprises a doping element selected from the group consisting of lanthanides elements, group IIIA elements, and group IIB elements. In one embodiment the doping element comprises a lanthanide element selected from the group consisting of lanthanum (La), cerium (Ce), ytterbium (Yb), praseodymium (Pr), europium (Eu), lutetium (Lu), erbium (Er), dysprosium (Dy), neodymium (Nd), samarium (Sm), gadolinium (Gd), terbium (Tb), holmium (Ho), and thulium (Tm). In another embodiments the doping element comprises a group IIIA element selected from the group consisting of gallium (Ga), and indium (In). In a particular embodiment the doping element comprises a group IIIB element selected from the group consisting of scandium (Sc), and yttrium (Y). In some embodiments, the doping element is selected from the group consisting of lanthanum (La), yttrium (Y), cerium (Ce), ytterbium (Yb), praseodymium (Pr), europium (Eu), scandium (Sc), lutetium (Lu), erbium (Er), gallium (Ga), dysprosium (Dy), and indium (In).

In some embodiment the dopant precursor comprises an organometallic precursor. In such embodiments the dopant precursor can comprise the doping element and a ligand selected from a group consisting of cyclopentadienyl, beta-diketonate, amidinate, or amidate.

The exemplary methods provided above for depositing a flowable layer structure can also comprise configuring the various layers of the super-lattice structure to improve the reflow properties of the flowable structure.

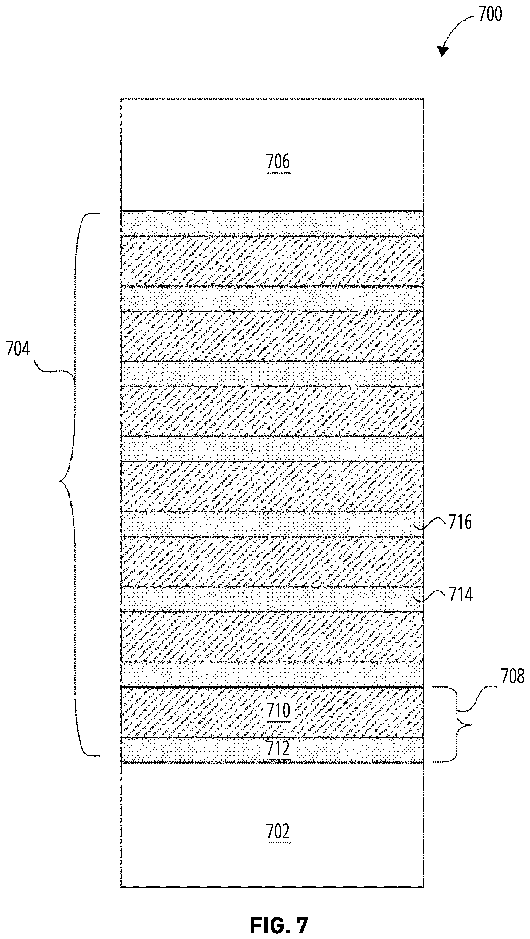

FIG. 7 illustrates an exemplary flowable layer structure 700 depositing by the methods described above. Flowable layer structure 700 can include an initial aluminum oxide layer 702, a super-lattice structure 704 deposited on the initial aluminum oxide layer 702, and a capping aluminum oxide layer 706 deposited on the super-lattice structure 704.

In various embodiments the flowable layer structure 700 of FIG. 7 comprises a super-lattice structure 704 which comprises two or more repeating unit layer structures 708. For example, each unit layer structure 708 can comprise an aluminum oxide layer 710 and a doping metal oxide layer 712 forming an aluminum oxide/doping metal oxide bilayer. In such examples adjacent doping metal oxide layers in the super-lattice structure 704 can comprise different doping elements having a different ionic radius. In addition, in such examples, adjacent doping metal oxide layers in the super-lattice structure 704 can comprise different doping elements having a different coordination number. Without intending to be bound by any theory, it is believed that a super-lattice structure with a high variation in ionic radii and coordination number between adjacent doping metal oxide layers increases the disorder in the super-lattice structure thereby keeping the flowable layer structure amorphous and with improved reflow properties, such as, a reduction in the glass transition temperature at which temperature the flowable layer structure is mobile.

In one or more embodiments the flowable layer structure 700 (FIG. 7) comprising two or more aluminum oxide/doping metal oxide bilayers (as illustrated by unit layer structure 708). In such embodiments adjacent doping metal oxide layers, such as for example, a first doping metal oxide layer 714 and a second doping metal oxide layer 716, in the super-lattice structure 704 comprise different doping elements having a different ionic radius.

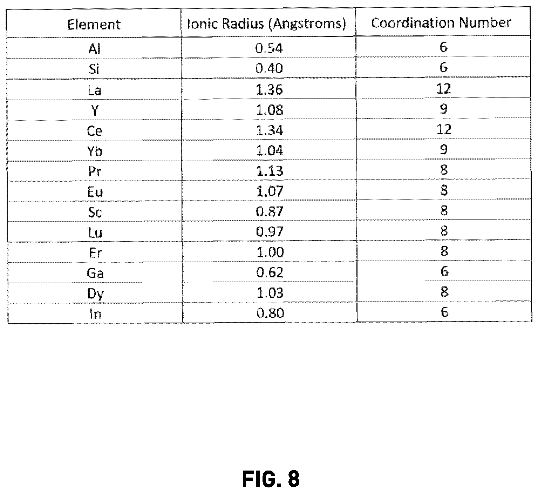

The table shown in FIG. 8 lists the various elements in the flowable layer structures of the disclosure, along with their corresponding ionic radius in Angstroms (Å) and their coordination number. In one or more embodiments the difference in the ionic radius between the doping elements in adjacent doping metal oxide layers (e.g., layers 714 and 716) of the super-lattice structure 704 is between 0.04 Å and 0.74 Å. In some embodiments, the difference in the ionic radius between the doping elements in adjacent doping metal oxide layers (e.g., layers 714 and 716) is greater than 0.04 Å, greater than 0.11 Å, greater than 0.21 Å, greater than 0.34 Å, greater than 0.37 Å, greater than 0.42 Å, greater than 0.49 Å, or equal to or greater than 0.74 Å. In one or more embodiments the difference in the coordination number between the doping elements in adjacent doping metal oxide layers (e.g., layers 714 and 716) of the super-lattice structure 704 is between 3 and 6. In some embodiments, the difference in the coordination number between the doping elements in adjacent doping metal oxide layers (e.g., layers 714 and 716) is equal to or greater than 1, greater than 2, greater than 3, greater than 4, or equal to 6.

In addition, in one or more embodiments, each of the two or more aluminum oxide/doping metal oxide bilayers (as illustrated by unit layer structure 708) comprise adjacent aluminum oxide layers (e.g., aluminum oxide layer 710) and doping metal oxide layers (e.g., doping metal oxide layer 712) having a difference in ionic radius and/or coordination number. In one or more embodiments the difference in the ionic radius between an aluminum oxide layer and a doping metal oxide layer comprising a unit layer structure 708 is between 0.22 Å and 0.82 Å. In some embodiments, the difference in the ionic radius between an aluminum oxide layer and a doping metal oxide layer comprising a unit layer structure 708 is greater than 0.22 Å, or less than or equal to 0.82 Å. In one or more embodiments the difference in the coordination number between an aluminum oxide layer and a doping metal oxide layer comprising a unit layer structure 708 is between is between 2 and 6. In some embodiments, the difference in the coordination number between an aluminum oxide layer and a doping metal oxide layer comprising a unit layer structure 708 is greater than greater than 2, or equal to or less than 6.

In various embodiments the flowable layer structure comprises a structure having an aluminum content between 50 atomic precent (atomic-%) and 90 atomic-%, between 60 atomic-% and 90 atomic-%, or between 80 atomic-% and 90 atomic-%. In some embodiments the flowable layer structure comprises a structure having a silicon content between 0 atomic-% and 45 atomic-%. In some embodiments the flowable layer structure comprises a structure having a silicon content between 1 atomic-% and 45 atomic-%, between 1 atomic-% and 30 atomic-%, or between 1 atomic-% and 25 atomic-%. In some embodiments the flowable layer structure comprises a structure having a doping element content between 1 atomic-% and 20 atomic-%.

In various embodiments the flowable layer structure comprises a structure having a total average layer thickness of less than 1000 Å, less than 750 Å, less than 500 Å, less than 250 Å, less than 150 Å, less than 100 Å, less than 50 Å, less than 25 Å, less than 10 Å, or between 10 Å and 1000 Å.

In particular embodiments a flowable layer structure (such as flowable layer structure 700 of FIG. 7) may comprise an initial aluminum oxide layer 702 (e.g., an AlOₓ layer or an AlSiₓO_{y} layer) deposited on the substrate by performing 10 or more repetitions of the first sub-cycle of first ALD process 302.

In particular embodiments the super-lattice structure 704 can be deposited on the initial aluminum oxide layer 702. In such embodiments the super-lattice structure may comprise 4 or more aluminum oxide/doping metal oxide bilayers (i.e., unit layer structures). In such examples the aluminum oxide components of the super-lattice structure can deposited by performing between 1 and 5 repetitions of the first sub-cycle of the first ALD process 302, and the doping metal oxide components of the super-lattice structure can be deposited by performing between 1 and 5 repetitions of the second sub-cycle of the second ALD process 304. In particular embodiments the first bilayer (deposited on the initial aluminum oxide layer) can comprise a lanthanum oxide doping metal oxide layer and an aluminum oxide layer. In particular embodiments the second bilayer (deposited on the first bilayer) can comprise a scandium oxide doping metal oxide layer and an aluminum oxide layer. In particular embodiments the third bilayer (deposited on the second bilayer) can comprise an aluminum oxide layer and at least one of an yttrium oxide doping metal oxide layer, a europium oxide doping metal oxide layer, a cerium oxide doping metal oxide layer, a praseodymium oxide doping metal oxide layer, a ytterbium oxide doping metal oxide layer, or a dysprosium oxide doping metal oxide layer. In particular embodiments the fourth bilayer (deposited on the third bilayer) can comprise an aluminum oxide layer and at least one of a lutetium oxide doping metal oxide layer, an erbium oxide doping metal oxide layer, a gallium oxide doping metal oxide layer, or an indium oxide doping metal oxide layer.

In particular embodiments a capping aluminum oxide layer 706 (e.g., an AlOₓ layer or an AlSiₓO_{y} layer) can be deposited on the super-lattice structure 704 by performing 10 or more repetitions of the first sub-cycle of the first ALD process 302.

FIG. 5 illustrates a structure 500 which comprises the previously described structure 400 of FIG. 4 (including the substrate 402 and the recessed feature 404) after the deposition of the flowable layer structure 700 over the substrate 402 and particularly over the recessed feature 404. As illustrated in FIG. 5, the flowable layer structure 700 is deposited conformally over the non-planar substrate 402. In various embodiments the flowable layer structure 700 is deposited in an amorphous state. In such embodiments the flowable layer structure 700 is a conformal amorphous glass.

Returning to method 100 of FIG. 1, having deposited the flowable layer structure on the substrate, the method 100 may further comprise heating the flowable layer structure at a temperature equal to or greater than the glass transition temperature of the flowable layer structure (step 106). As used herein the term "glass transition temperature (T_{g})" can refer to the temperature at which flow is initiated in the flowable layer structure. In particular embodiments the glass transition temperature of the flowable layer structure is less than 1000 °C, less than 900 °C, less than 800 °C, less than 700 °C, less than 600 °C, less than 500 °C, or between 500 °C and 1000 °C.

In one or more embodiments the flowable layer structure is heated above the glass transition temperature of the flowable layer structure in an environment comprising water vapor. In some embodiments step 106 of method 100 comprising heating the flowable layer structure above the glass transition temperature is performed in an environment comprising water vapor to induce the reflow of the flowable layer structure thereby at least partially filling the recessed feature on the substrate. In some embodiments the flowable layer structure is heated within a reaction chamber having a steam environment. In such embodiments, prior to heating the substrate, with the flowable layer structure thereon, steam is introduced into the reaction chamber.

For example, FIG. 6 illustrates a structure 600 which comprises the previously described structure 500 of FIG. 5 (including the substrate 402, the recessed feature 404, and the flowable layer structure) after heating the flowable layer structure above the glass transition temperature, i.e., after completion of step 106 of method 100. As illustrated in FIG. 6, the flowable layer structure 700 fills the recessed feature 404 without the formation of an unwanted seam. In various embodiments the flowable layer structure 700 fills the recessed feature in a seam-less manner, i.e., without void formation in the recessed feature.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A method for filling a recessed feature on a substrate disposed within a reaction chamber, the method comprising:
depositing a flowable layer structure on the substrate by performing a plurality of deposition super-cycles of an atomic layer deposition process, each one of the plurality of deposition super-cycles comprising:
performing one or more first sub-cycles of a first ALD process to deposit an aluminum oxide layer, each one of the one or more first sub-cycles comprising: introducing an aluminum precursor into the reaction chamber; and introducing a first oxygen reactant into the reaction chamber; and
performing one or more second sub-cycles of a second ALD process to deposit a doping metal oxide layer, each one of the one or more second sub-cycles comprising: introducing one or more dopant precursors; and introducing a second oxygen reactant, wherein the one or more dopant precursors comprise a doping element having an oxidation state equal to the oxidation state of aluminum and an ionic radius different to that of aluminum; and
heating the flowable layer structure at a temperature equal to or greater than the glass transition temperature of the flowable layer structure.

2. The method of claim 1, wherein the doping element is selected from the group consisting of lanthanides elements, group IIIA elements, and group IIB elements.

3. The method of claim 2, wherein the doping element is selected from the group consisting of lanthanum (La), yttrium (Y), cerium (Ce), ytterbium (Yb), praseodymium (Pr), europium (Eu), scandium (Sc), lutetium (Lu), erbium (Er), gallium (Ga), dysprosium (Dy), and indium (In).

4. The method of claim 3, wherein the flowable layer structure comprises a super-lattice structure comprising two or more repeating unit layer structures, each unit layer structure comprising an aluminum oxide/doping metal oxide bilayer, wherein adjacent doping metal oxide layers in the super-lattice structure comprise different doping elements having a different ionic radius.

5. The method of claim 4, wherein the difference in ionic radius between the doping elements in adjacent doping metal oxide layers of the super-lattice structure is between 0.04 Angstroms and 0.74 Angstroms.

6. The method of claim 5, wherein adjacent doping metal oxide layers in the super-lattice structure comprise different doping elements having a different coordination number.

7. The method of claim 6, wherein the difference in the coordination number between the doping elements in adjacent doping metal oxide layers of the super-lattice structure is between 1 and 6.

8. The method of claim 4, further comprising:
performing one or more first sub-cycles to deposit an initial aluminum oxide layer on the substrate prior to depositing the super-lattice structure; and
performing one or more first sub-cycles to deposit a capping aluminum oxide layer on the super-lattice structure.

9. The method of claim 1, wherein each one of the first sub-cycles further comprises introducing a silicon precursor into the reaction chamber.

10. The method of claim 1, wherein heating the flowable layer structure further comprises thermally annealing the flowable layer structure in an environment comprising water vapor.

11. A method for filling a recessed feature on a substrate with a flowable layer structure, the method comprising:
performing an atomic layer deposition (ALD) process for depositing a super-lattice structure comprising two or more repeated aluminum silicate (AlSiₓO_{y})/doping metal oxide (MO_{z}) bilayers, the ALD process comprising a deposition super-cycle comprising alternately and sequentially performing one or more first sub-cycles and one or more second sub-cycles;
wherein each cycle of the first sub-cycles comprises alternately and sequentially contacting the substrate with an aluminum precursor, a silicon precursor, and a first oxygen precursor;
wherein each cycle of the second sub-cycles comprises alternatively and sequentially contacting the substrate with a dopant precursor and a second oxygen reactant; and
wherein adjacent AlSiₓO_{y}/MO_{z} bilayers in the super-lattice structure are deposited employing a different dopant precursor such each of the adjacent AlSiₓO_{y}/MO_{z} bilayers comprises a doping element that is different, having a different ionic radius and a different coordination number; and
heating the flowable layer structure at a temperature equal to or greater than the glass transition temperature of the flowable layer structure.

12. The method of claim 11, wherein the difference in ionic radius between the doping elements in adjacent doping metal oxide layers of the super-lattice structure is between 0.04 Angstroms and 0.74 Angstroms.

13. The method of claim 12, wherein the difference in the coordination number between the doping elements in adjacent doping metal oxide layers of the super-lattice structure is between 1 and 6.

14. The method of claim 13, further comprising:
performing one or more first sub-cycles to deposit an initial AlSiₓO_{y} layer on the substrate prior to depositing the super-lattice structure; and
performing one or more first sub-cycles to deposit a capping AlSiₓO_{y} layer on the super-lattice structure.

15. The method of claim 11, wherein the doping element comprises a lanthanide element selected from the group consisting of lanthanum (La), cerium (Ce), ytterbium (Yb), praseodymium (Pr), europium (Eu), lutetium (Lu), erbium (Er), dysprosium (Dy).

16. The method of claim 11, wherein the doping element comprises a group IIIA element selected from the group consisting of gallium (Ga), and indium (In).

17. The method of claim 11, wherein the doping element comprises a group IIIB element selected from the group consisting of scandium (Sc), and yttrium (Y).

18. A method for filling a recessed feature on a substrate disposed within a reaction chamber, the method comprising:
depositing a flowable doped aluminum silicate (AlSiₓO_{y}) layer structure at least partially within the recessed feature of the substrate, the doped AlSiₓO_{y} structure comprising:
an initial AlSiₓO_{y} layer,
a super-lattice structure disposed on the initial AlSiₓO_{y} layer and comprising two or more repeated AlSiₓO_{y}/metal oxide (MO_{z}) bilayers, wherein adjacent metal oxide (MO_{z}) layers in the super-lattice structure each comprise a different doping element having a different ionic radius and a different coordination number; and
a capping AlSiₓO_{y} layer disposed on the super-lattice structure; and
heating the flowable doped aluminum silicate (AlSiₓO_{y}) layer structure above a glass transition temperature of the flowable doped aluminum silicate (AlSiₓO_{y}) layer structure in an environment comprising water vapor to induce reflow of the flowable doped aluminum silicate (AlSiₓO_{y}) layer structure thereby at least partially filling the recessed feature.

19. The substrate processing method of claim 18, wherein the super-lattice structure is deposited by performing a plurality of deposition super-cycles of an atomic layer deposition process, each one of the plurality of deposition super-cycles comprising:
performing one or more of first sub-cycles to deposit an AlSiₓO_{y} layer, each one of the plurality of the first sub-cycles comprising: introducing an aluminum precursor into the reaction chamber; introducing a silicon precursor into the reaction chamber, and introducing a first oxygen reactant into the reaction chamber; and
performing one or more of second sub-cycles to deposit a doping metal oxide layer, each one of the plurality of the second sub-cycles comprising: introducing one or more dopant precursors; and introducing a second oxygen reactant.

20. The substrate processing method of claim 19, wherein the first sub-cycle is performed between 1 and 10 times, and the second sub-cycle is performed between 1 and 5 times.
